Europäisches Patentamt

**European Patent Office**

**Office européen des brevets**

(11) Veröffentlichungsnummer: **0 045 715**
**B1**

(12) **EUROPÄISCHE PATENTSCHRIFT**

(45) Veröffentlichungstag der Patentschrift:
13.02.85

(51) Int. Cl.⁴: **H 02 B 1/18**

(21) Anmeldenummer: **81730064.3**

(22) Anmeldetag: **03.07.81**

(54) Metallgekapselte, druckgasisolierte Hochspannungsanlage.

(30) Priorität: **04.08.80 DE 3029778**

(43) Veröffentlichungstag der Anmeldung:
**10.02.82 Patentblatt 82/6**

(45) Bekanntmachung des Hinweises auf die Patenterteilung:
**13.02.85 Patentblatt 85/7**

(84) Benannte Vertragsstaaten:
**CH FR LI SE**

(56) Entgegenhaltungen:
**DE - A - 2 155 398**
**DE - A - 2 325 445**
**DE - A - 2 647 106**

(73) Patentinhaber: **Siemens Aktiengesellschaft, Berlin und München Wittelsbacherplatz 2, D-8000 München 2 (DE)**

(72) Erfinder: **Mamet, Manfred, Dipl.-Ing., Thaliaweg 11, D-1000 Berlin 46 (DE)**
Erfinder: **Fischer, Dietrich, Altenburger Allee 3, D-1000 Berlin 19 (DE)**
Erfinder: **Tümmler, Gerhard, Rohrdamm 54, D-1000 Berlin 13 (DE)**
Erfinder: **Niederhüfner, Detlev, Coesfelder Weg 3 D, D-1000 Berlin 27 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Beschreibung

Die Erfindung bezieht sich auf eine metallgekapselte, druckgasisolierte Hochspannungsschaltanlage, bei welcher Anlageteile durch Trennschalter freigeschaltet und jeweils mittels eines Erdungsschalters mit der geerdeten Kapselung verbindbar sind, wobei zur Erfassung der Spannung der gekapselten Leiter benachbart zum Erdungsschalter im Bereich der Innenoberfläche der Kapselung, gegenüber dieser isoliert, jeweils mit einem Meßanschluß und einem Anzeigegerät verbindbare Meßelektroden vorgesehen sind, die mit den ihnen zugeordneten Leitern die Hochspannungs-Kondensatoren von kapazitiven Spannungsteilern bilden.

Eine derartige Anlage ist aus der DE-A-2 155 398 bekannt. In dieser ist beschrieben, daß zur einfachen Erkennung des freigeschalteten Zustandes eines abgetrennten Anlageteils im Innern der Kapselung eine kapazitive Spannungsmessung vorgenommen wird. Diese erfolgt mit Hilfe einer Meßelektrode, die benachbart zum Erdungsschalter isoliert im Bereich der Innenoberfläche der Kapselung angeordnet ist. Die Meßelektrode ist ringförmig ausgebildet und umfaßt das bewegliche Schaltstück des Erdungsschalters berührungslos. Pro Phase und Erdungsschalter ist also jeweils eine Meßelektrode vorgesehen.

Der Erfindung liegt die Aufgabe zugrunde, den Aufwand für eine derartige Feststellung des freigeschalteten Zustandes von Anlageteilen mit Hilfe einer kapazitiven Spannungsmessung zu verringern. Zur Lösung dieser Aufgabe sind bei einer dreiphasig metallgekapselten, druckgasisolierten Hochspannungsschaltanlage der eingangs beschriebenen Art gemäß der Erfindung zwei stiftförmig ausgebildete Meßelektroden mit abgerundetem Ende jeweils in der Mittelebene zwischen zwei der drei Leiter derart angeordnet, daß ihr abgerundetes Ende geringfügig in den Innenraum der Kapselung hineinragt.

Eine derartige Meßanordnung hat den Vorteil, daß mit nur zwei Meßelektroden der spannungsfreie oder spannungsführende Zustand einer dreiphasigen gekapselten Anlage eindeutig festgestellt werden kann. Durch die stiftförmige Ausbildung der Meßelektrode mit abgerundetem Ende, die zudem nur wenig in den Kapselungsinnenraum hineinragt, wird das im Innern der Kapselung herrschende elektrische Feld nur sehr geringfügig verzerrt. Außerdem sind die stiftförmigen Meßelektroden jeweils mittig zwischen zwei der drei Leiter angeordnet, d. h., an einer freien Stelle in der Wand der Kapselung. Je nach Art der verwendeten Erdungsschalter liegt bei einem Sternerder die Meßelektrode in der Mantelwand der Kapselung, d. h., an der Begrenzung des Gasraumes, und ragt radial in den Hochspannungsraum hinein. Bei einem Parallelerder liegt die Meßelektrode auf der Antriebsplatte für die Erdungsschalter, d. h., innerhalb des Gasraumes, und ragt axial in den Hochspannungsraum hinein.

Um den für die Messung erforderlichen Meßwertaufnehmer am Übergang vom Gasraum innerhalb der Kapselung zum Außenraum möglichst leicht montierbar und in kompakter Bauweise zu gestalten, ist es vorteilhaft, daß die stiftförmige Meßelektrode isoliert in der Stirnwand eines zylinderförmigen metallischen Gehäuses eingesetzt ist, das mit der Kapselungswand leitend verbunden ist, wobei das andere, mit dem Meßanschluß zu verbindende Ende der Meßelektrode in einem gasdicht zur Kapselung abgeschlossenen Hohlraum des Gehäuses liegt. Es empfiehlt sich weiterhin, daß der Hohlraum durch eine obere Stirnwand abgeschlossen ist, in die eine mit der Meßelektrode über einen Steckkontakt verbundene koaxiale Buchse eingesetzt ist, die über eine Kurzschließkappe geerdet werden kann. Auf diese Weise steht der Hohlraum innerhalb des Gehäuses für die Aufnahme des Steckanschlusses und gegebenenfalls notwendiger Schutzmittel zur Verfügung, und aus der oberen Stirnwand ragt allein die koaxiale Buchse für den Anschluß an die eigentliche Meßanordnung, d. h. das Anzeigegerät, hinaus. Da die Spannungsmessung zur Nachprüfung des freigeschalteten Zustandes der Anlageteile jeweils nur zu besonderen Zeitpunkten notwendig ist, wird durch die Kurzschließkappe während des normalen Betriebes eine einwandfreie Erdung dieses in die Kapselung eingesetzten Teils der Meßanordnung erreicht.

Für den Fall des Parallelerders, wo die Meßelektrode selbst innerhalb des Gasraumes liegt, ist es zweckmäßig, ein gleichartig aufgebautes Gehäuse für den Durchtritt durch die Kapselungswand zu verwenden. Man braucht dann lediglich die stiftförmige, isoliert in der unteren Stirnwand eingesetzte Meßelektrode durch einen beidseitig den Anschluß eines abgeschirmten koaxialen Meßkabels ermöglichenden Anschlußteil gleicher Abmessungen zu ersetzen; denn auch auf der Außenseite des Gehäuses erfolgt die Verbindung zwischen der im Gasraum liegenden stiftförmigen Meßelektrode und diesem Anschlußteil mittels eines abgeschirmten koaxialen Meßkabels.

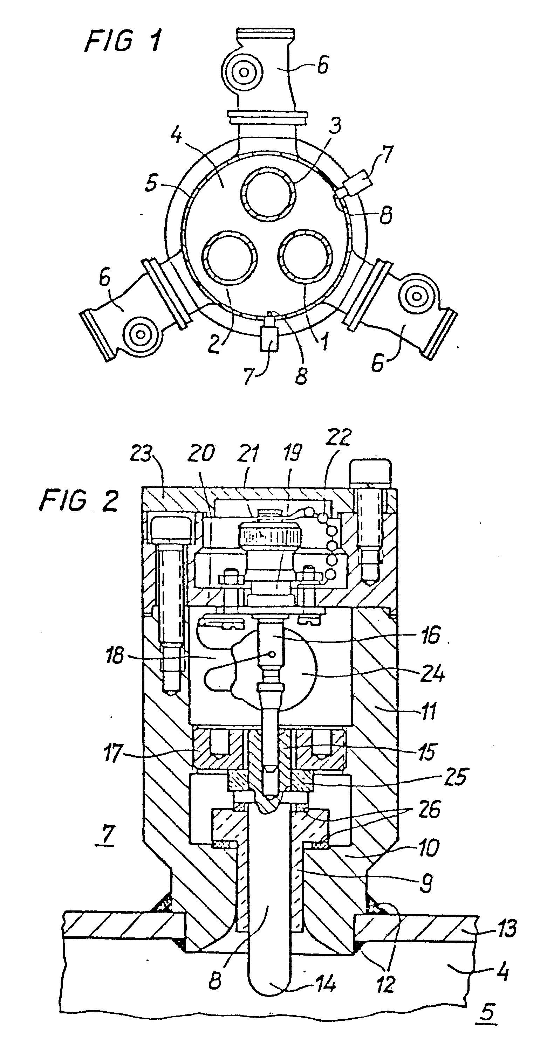

Im folgenden sei die Erfindung noch anhand des in den Fig. 1 und 2 der Zeichnung dargestellten Ausführungsbeispiels näher erläutert.

Fig. 1 zeigt, schematisch dargestellt, einen Schnitt durch eine dreiphasig metallgekapselte Hochspannungsschaltanlage mit Sternerder; in der

Fig. 2 ist ein Schnitt durch einen in der Mantelwand der Kapselung eingesetzten Meßwertaufnehmer dargestellt.

Bei einer dreiphasigen, metallgekapselten, druckgasisolierten Hochspannungsschaltanlage liegen die drei Leiter 1, 2, 3 der drei Phasen des Systems rotationssymmetrisch angeordnet im Innenraum 4 der metallischen und geerdeten Kapselung 5. Jedem Leiter 1, 2, 3 genau zugeordnet ist ein Erdungsschalter 6 eines Sternerders, durch den der Anlageteil nach Spannungsfreischaltung geerdet werden kann. Diese Erdung darf nur vorgenommen werden, nachdem der spannungsfreie Zustand des Anlageteils einwandfrei festgestellt wurde. Hierzu sind in der Kapselung 5 zwei Meßwertaufnehmer 7 mit stiftförmig ausgebildeten Meßelektroden 8 jeweils mittig zwischen zwei der drei Leiter 1, 2 bzw. 3, 1 so angeordnet, daß das abgerundete Ende der Meßelektroden 8 in den Innenraum 4 der Kapselung 5 hineinragt. Diese Meßwertaufnehmer 7 können jeweils mit dem nicht dargestellten Meß-anschluß einer Meßwertanzeigevorrichtung ver-bunden werden. Durch die Meßelektroden 8 wird jeweils das Vorhandensein einer Spannung oder ein spannungsfreier Zustand erfaßt, so daß man ein einwandfreies Bild über den Zustand des Anlageteils erhält.

Bei dem Sternerder liegen die Meßelektroden 8 isoliert in der Mantelwand der Kapselung 5, d. h., in der Begrenzung zwischen dem gasgefüllten Innenraum 4 in der Kapselung 5 und dem Außenraum. Der Meßwertaufnehmer 7 muß da-her eine gasdicht ausgebildete Anschlußmög-lichkeit für das zum Anzeigegerät führende abgeschirmte Koaxialkabel aufweisen. Die Fig. 2 zeigt den Meßwertaufnehmer 7 hinsichtlich seines konstruktiven Aufbaus im einzelnen.

Die stiftförmige Meßelektrode 8 ist über einen Isolierkörper 9 isoliert in der unteren Stirnwand 10 eines zylinderförmigen metallischen Gehäuses 11 eingesetzt, das über Schweißnähte 12 leitend mit der Kapselungswand 13 verbunden ist. Das abgerundete Ende 14 der Meßelektrode 8, das halbkugelförmig ausgebildet ist, ragt in den Innenraum 4 der Kapselung 5 hinein. Um einerseits einen eindeutigen Meßwert erfassen zu können, aber andererseits das elektrische Feld im Innern der Kapselung 5 möglichst wenig zu stören bzw. zu verzerren, ist es ausreichend, daß das abgerundete Ende 14 angenähert bis 20 mm in den Innenraum 4 der Kapselung hineinragt.

Das andere Ende 15 der Meßelektrode 8, welches mit dem Meßanschluß 16 zu verbinden ist, liegt in einem durch eine Druckmutter 17, einem isolierten Distanzring 25 und Dichtungsringen 26 gasdicht zur Kapselung 5 abgeschlossenen Hohlraum 18 des Gehäuses 11. Der Meßanschluß 16 zur Meßelektrode 8 ist als Steckkontakt ausgebildet und führt zu einer koaxialen Buchse 19, die in der oberen Stirnwand 20 eingesetzt ist, die den Hohlraum 18 abschließt. Da die Messungen jeweils nur zu bestimmten Zeiten durchgeführt werden müssen, d. h. sehr selten — gemessen an der Gesamtbetriebszeit der Anlage, ist eine Kurzschließkappe 21 vorgesehen, die über eine Kette 22 beweglich, aber unverlierbar an der Stirnwand 20 befestigt ist. Durch diese Kurzschließkappe 21 wird die koaxiale Buchse 19 in den Zeiträumen, in denen keine Messung vorgenommen wird, abgeschlossen und geerdet. Zusätzlich ist der Meßwertaufnehmer 7 durch einen Deckel 23 geschützt.

Außerdem ist der Meßwertaufnehmer 7 zum Schutz gegen Überspannungen mit einem Varistor 24 beschaltet. Dieser ist in dem Hohlraum 18 angeordnet und liegt zwischen Meßelektrode 8 und Erde.

Der so aufgebaute Meßwertaufnehmer 7 ergibt eine sehr kompakte Bauweise und eine gün-stige Ausführungsform hinsichtlich der gasdich-ten Ausführung zwischen Hochspannungsraum und Meßwertaufnehmer 7. Das Einsetzen des Meßwertnehmers 7 in die Kapselungswand 13 läßt sich einfach durchführen.

Liegt dagegen die Meßelektrode 8 insgesamt innerhalb des Gasraumes der Kapselung 5, wie dies bei einem Parallelerder auftreten kann, so kann ebenfalls ein konstruktiv gleich ausgebildeter Meßwertaufnehmer 7 für den Durchtritt der Meßanordnung durch die Kapselungswand 13 verwendet werden, dann ist lediglich auch auf der dem Innenraum 4 der Kapselung 5 zugewandten Seite der Meßelektrode 8 eine Anschlußmöglichkeit für ein koaxiales Meßkabel vorzusehen, welches die Verbindung zur eigentlichen im Gasraum liegenden Meßelektrode 8 herstellt.

**Patentansprüche**

1. Metallgekapselte, druckgasisolierte Hochspannungsschaltanlage, bei welcher Anlageteile durch Trennschalter freigeschaltet und jeweils mittels eines Erdungsschalters (6) mit der geerdeten Kapselung (5) verbindbar sind, wobei zur Erfassung der Spannung der gekapselten Leiter (1, 2, 3), benachbart zum Erdungsschalter, im Bereich der Innenoberfläche der Kapselung (5), gegenüber dieser isoliert, jeweils mit einem Meßanschluß (16) und einem Anzeigegerät verbindbare Meßelektroden (8) vorgesehen sind, die mit den ihnen zugeordneten Leitern (1, 2, 3) die Hochspannungskondensatoren von kapazitiven Spannungsteilern bilden, dadurch gekennzeichnet, daß bei einer dreiphasig gekapselten Anlage zwei stiftförmig ausgebildete Meßelektroden (8) mit abgerundetem Ende (14) jeweils in der Mittelebene zwischen zwei (1, 2; 3, 1) der drei Leiter (1, 2, 3) derart angeordnet sind, daß ihr abgerundetes Ende (14) geringfügig in den Innenraum (4) der Kapselung (5) hineinragt.

2. Hochspannungsschaltanlage nach Anspruch 1, dadurch gekennzeichnet, daß das abgerundete Ende (14) der Meßelektrode (8) halbkugelförmig ausgebildet ist.

3. Hochspannungsschaltanlage nach Anspruch 1 oder 2, dadurch gekennzeichnet, daß das abgerundete Ende (14) angenähert bis 20 mm in den Innenraum (4) der Kapselung (5) hineinragt.

4. Hochspannungsschaltanlage nach Anspruch 1, dadurch gekennzeichnet, daß die stiftförmige Meßelektrode (8) isoliert in der unteren Stirnwand (10) eines zylinderförmigen metallischen Gehäuses (11) eingesetzt ist, das mit der Kapselungswand (13) leitend verbunden ist, wobei das andere mit dem Meßanschluß (16) zu verbindende Ende (15) der Meßelektrode (8) in einem gasdicht zur Kapselung (5) abgeschlossenen Hohlraum (18) des Gehäuses (11) liegt.

5. Hochspannungsschaltanlage nach Anspruch 4, dadurch gekennzeichnet, daß in dem Hohlraum (18) ein Varistor (24) angeordnet und zwischen Meßelektrode (8) und Erde geschaltet ist.

6. Hochspannungsschaltanlage nach Anspruch 4 oder 5, dadurch gekennzeichnet, daß der Hohlraum (18) durch eine obere Stirnwand (20) abgeschlossen ist, in die eine mit der Meßelektrode (8) über einen als Steckkontakt ausgebildeten Meßanschluß (16) verbundene koaxiale Buchse (19) eingesetzt ist, die über eine Kurzschließkappe (21) geerdet werden kann.

7. Hochspannungsschaltanlage nach Anspruch 6, dadurch gekennzeichnet, daß die Kurzschließkappe (21) mittels einer Kette (22) beweglich, aber unverlierbar an der Stirnwand (20) befestigt ist.

8. Hochspannungsschaltanlage nach Anspruch 6, dadurch gekennzeichnet, daß ein Deckel (23) auf die obere Stirnwand (20) aufgesetzt ist.

## Claims

1. A metal-encased, pressure-gas-insulated, high voltage switchgear; in which parts of the switchgear are isolated by means of isolating switches and can each be connected by means of an earthing switch (6) to the earthed casing (5), where, in order to measure the voltage of the encased conductors (1, 2, 3) adjacent to the earthing switch, in the region of the inner surface of the casing (5) but insulated therefrom, there are arranged measuring electrodes (8) which can each be connected to a measuring terminal (16) and a display device and which, together with the conductors (1, 2, 3) to which they are assigned, form the high voltage capacitors of capacitive voltage dividers, characterised in that in a three-phase encased switchgear, two pin-shaped measuring electrodes (8) having rounded ends (14) are in each case arranged in the central plane between two (1, 2; 3, 1) of the three conductors (1, 2, 3) in such manner that the rounded end (14) projects slightly into the interior (4) of the casing (5).

2. High voltage switchgear as claimed in Claim 1, characterised in that the rounded end (14) of the measuring electrode (8) is hemispherical.

3. High voltage switchgear as claimed in Claim 1 or Claim 2, characterised in that the rounded end (14) projects into the interior (4) of the capsule (5) for about 20 mm.

4. High voltage switchgear as claimed in Claim 1, characterised in that the pin-shaped measuring electrode (8) is inserted in insulated manner in the lower end wall (10) of a cylindrical metallic housing (11) which is conductively connected to the casing wall (13), the other end (15) of the measuring electrode (8), which end is to be connected to the measuring terminal (16), being located in a cavity (18) in the housing (11), which cavity is sealed in gas-tight fashion from the casing (5).

5. High voltage switchgear as claimed in Claim 4, characterised in that a varistor (24) is arranged in the cavity (18) and is connected between the measuring electrode (8) and earth.

6. High voltage switchgear as claimed in Claim 4 or Claim 5, characterised in that the cavity (18) is sealed by an upper end wall (20) into which there is inserted a co-axial bushing (19) which is connected to the measuring electrode (8) through a measuring terminal (16), which represents a plug-in contact, and which can be earthed through a short-circuiting cap (21).

7. High voltage switchgear as claimed in Claim 6, characterised in that the short-circuiting cap (21) is attached to the end wall (20) by means of a chain (22) so that it can be moved but not lost.

8. High voltage switchgear as claimed in Claim 6, characterised in that a cover (23) is placed on the upper end wall (20).

## Revendications

1. Installation de coupure de haute tension à blindage métallique et à isolation par un gaz sous pression, dans laquelle des éléments de l'installation sont isolés à l'aide de sectionneurs et sont, respectivement, susceptibles d'être reliés au blindage (5) mis à la terre, à l'aide d'un interrupteur de mise à la terre (6), du type dans lequel, pour saisir la tension des conducteurs blindés (1, 2, 3), on prévoit dans le voisinage de l'interrupteur de mise à la terre, dans l'environnement de la surface de blindage (5) et isolées par rapport à ce dernier, des électrodes de mesure (8) susceptibles d'être reliées respectivement à un branchement de mesure et à un appareil indicateur, lesdites électrodes de mesure formant avec les conducteurs (1, 2, 3) qui leur sont associés, les condensateurs haute tension de diviseurs de tension capacitifs, caractérisée par le fait que dans le cas d'une installation triphasée blindée, deux électrodes de mesure (8) en forme de chevilles et à extrémités arrondies (14) sont disposées, respectivement, dans le plan médian entre deux (1, 2; 3, 1) des trois conducteurs (1, 2, 3) de manière que les extrémités arrondies (14) pénètrent respectivement et sur une petite distance dans l'espace intérieur (4) du blindage (5).

2. Installation de coupure de haute tension selon la revendication 1, caractérisée par le fait que l'extrémité arrondie (14) de l'électrode de mesure (8) est réalisée sous forme semi-sphérique.

3. Installation de coupure de haute tension selon la revendication 1 ou 2, caractérisée par le fait que l'extrémité arrondie (14) pénètre jusqu'à environ 20 mm dans l'espace intérieur (4) du blindage (5).

4. Installation de coupure de haute tension selon la revendication 1, caractérisée par le fait que l'électrode de mesure (8) en forme de cheville est insérée, avec isolation, dans la paroi frontale inférieure (10) d'un boîtier métallique (11) de forme cylindrique, lequel boîtier est relié électriquement à la paroi (13) du blindage, l'autre extrémité (15) de l'électrode de mesure (8) qui est à relier avec le branchement de mesure (16) se situant dans une cavité (18) du boîtier (11), ladite cavité étant fermée de façon étanche au gaz par rapport au blindage (5).

5. Installation de coupure de haute tension selon la revendication 4, caractérisée par le fait que dans la cavité (18) est disposé un varistor (24) qui est monté entre l'électrode de mesure (8) et la terre.

6. Installation de coupoure de haute tension selon la revendication 4 ou 5, caractérisée par le fait que la cavité (18) est obturée à l'aide d'une paroi frontale supérieure (8) dans laquelle est insérée une douille coaxiale (19) qui est reliée à l'électrode de mesure (8), par l'intermédiaire d'un branchement de mesure (16) conformé suivant un contact à enfichage, ladite douille coaxiale est mise à la terre par l'intermédiaire d'un capot de court-circuit (21).

7. Installation de coupure de haute tension selon la revendication 6, caractérisée par le fait que le capot de court-circuit (21) est fixé de façon à être mobile, mais imperdable, à la paroi frontale (20), à l'aide d'une chaîne (22).

8. Installation de coupure de haute tension selon la revendication 6, caractérisée par le fait que sur la paroi frontale supérieure (20) est monté un couvercle (23).

**FIG 1**

**FIG 2**